# EUROPEAN PATENT APPLICATION

(11) **EP 4 624 104 A1**
(43) Date of publication of application: **01.10.2025**
(21) Application number: 24167558.6
(22) Date of filing: 28.03.2024
(51) Int. Cl.: B25F 5/02, H03K 17/955, H03K 17/96, H03K 17/975

(54) **HANDHELD ELECTRIC TOOL**

(71) Applicant: Hilti Aktiengesellschaft, 9494 Schaan (LI)
(72) Inventor: Lacher, Michael, 86830 Schwabmünchen (DE); Koschel, Christian, 86199 Augsburg (DE); Hummel, Helmut, 87616 Marktoberdorf (DE)
(74) Representative: Hilti Aktiengesellschaft Corporate Intellectual Property

(57) **Abstract**

The present invention provides a handheld electric tool (1), wherein the handheld electric tool (1) comprises a housing (2), a drive unit (4) and a control unit (8) for controlling the drive unit (4) are provided in the housing (2), and at least two sensor elements (31, 32, 33, 34) operably connected to the control unit (8) are provided. The electric tool (1) further comprises at least one gripping part (22, 26), and the at least two sensor elements (31, 32, 33, 34) are separately arranged on the gripping part (22, 26), forming at least one redundant sensor group (30, 40).

## Description

### TECHNICAL FIELD

The present invention relates to a handheld electric tool comprising a drive unit and a control unit used for actuating the drive unit, and at least two sensor elements operably connected to the control unit, as defined in the preamble of claim 1. The present invention also relates to a method for operating this electric tool.

### BACKGROUND ART

A handheld electric tool designed to have a sensor element is known. With the help of a sensor, a power switch may be activated, and then a drive unit is actuated by means of a switch that can be actuated by a user. However, as applications of electronic circuits and elements in electric tool products increasingly broaden, product safety issues brought about by the application of electronic circuits and elements is important increasingly. A safety critical function (SCF) is a function specified by a safety standard, and in abnormal conditions, loss of this function can lead to a user being exposed to a risk beyond what the safety standard allows. To meet a requirement of an SCF standard, a sensor system of an electric tool must have a redundant detection function, so as to ensure the electric tool is more reliable and stable when a fault occurs. Redundant detection technology is indispensable for safety, and is the basis for enabling an electric tool to comply with an SCF.

### SUMMARY OF THE INVENTION

An object of the present invention is to provide a handheld electric tool and a method for operating this electric tool that provides a sensitive and reliable redundant sensor system, so as to increase reliability and safety of the electric tool.

The present invention provides a handheld electric tool, comprising a drive unit and a control unit used for actuating the drive unit, and at least two sensor elements operably connected to the control unit. The electric tool further comprises at least one gripping part. The at least two sensor elements are separately arranged on the gripping part and/or have independent electronic signal processing parts, to form at least one failure tolerant redundant sensor groups. According to the handheld electric tool of the present invention, a sturdy and durable sensor system is provided. The sensor elements forming the failure tolerant redundant sensor group provide sufficient redundant sensor signals, and these signals can further verify each other, so as to ensure correct operation/detection. This is the basis for SCF conform design of a capacitive operator detection in a Power Tool.

The gripping part comprises a gripping region defining a gripping direction, and is used for holding and guiding the electric tool with one or both hands of a user contacting the gripping region at least partially around the gripping direction, and a length L in the gripping direction of each sensor element in the failure tolerant redundant sensor group is much greater than a width B thereof, wherein the width is a dimension of the sensor element substantially perpendicular to the gripping direction, and the width B > 0.1 mm. Thus, a desired high sensitivity to minute movements of a hand is obtained, while simultaneous activation of signals is maximally avoided.

According to a preferred embodiment of the present invention, two or more failure tolerant redundant sensor groups are provided on the gripping parts. Hence, a redundancy compensation system is formed between the redundant sensor elements of each of redundant sensor groups, and when one of the redundant sensor elements fails, an extra detection signal is provided by another redundant sensor elements within each redundant sensor group, thus forming a more sensitive and reliable sensor system, which can withstand scenarios of misuse such as of extreme water and dust, such that the electric tool is more reliable and stable.

Each redundant sensor group comprises at least two sensor elements, and the sensor elements of each redundant sensor group are arranged alternately at intervals from each other, and an interval between the sensor elements is greater than 10 mm. An appropriate interval between the sensor elements can better realize a redundancy compensation effect, and can withstand scenarios of misuse such as of extreme water and dust, increasing safety of operation and detection. Thus, the redundant sensor groups can jointly better realize a redundancy compensation effect.

The power tool comprises at least a first gripping part and a second gripping part, and the at least two redundant sensor groups are respectively arranged on the first gripping part and the second gripping part. Thus, by means of logic control, whether the two gripping parts are gripped by a user may be respectively assessed. It may be provided that when neither gripping part is gripped, the drive unit cannot be actuated. Alternatively, it may also be provided that when the first gripping part is gripped, and the second gripping part is not gripped, the drive unit may be conditionally actuated.

The sensor elements are capacitive sensors, which can achieve high perceptual sensitivity and quickly detect minute changes in the gripping region. Here, a capacitive sensor is in particular a sensor used for capacitance measurement and/or detection.

The present invention also provides a method for operating a handheld electric tool, the electric tool comprising a drive unit and a control unit used for actuating the drive unit, and at least two capacitive sensor elements operably connected to the control unit. The electric tool further comprises at least one gripping part, and the at least two sensor elements are separately arranged on the gripping part, forming at least one failure tolerant redundant sensor group. The method comprises the following steps:
- detecting a signal of each sensor element of the redundant sensor group, and comparing the signal with a given corresponding threshold value of each sensor element;
- when the signal of every sensor element of the redundant sensor group is greater than the given corresponding threshold value of each sensor element, the drive unit being actuated by means of the control unit.

An advantage of the method for actuating the handheld electric tool according to the present invention lies in that the risk of a detection error by the sensor elements is reduced in a simple way. By means of arranging redundant sensor groups on the gripping part of the electric tool, each sensor element in each redundant sensor group compensates for each other's redundancy, advantageously achieving redundant monitoring of a target being detected in a gripping region, for example a hand or finger, and thus achieving high safety for an operator during operation of the electric tool.

According to a preferred embodiment of the present invention, at least two redundant sensor groups are arranged on the gripping part, and the method further comprises:
- detecting a signal of each sensor element of first redundant sensor group, and comparing the signal with a given corresponding threshold value of each sensor element;
- detecting a signal of each sensor element of second and/or further redundant sensor group, and comparing the signal with a given corresponding threshold value of each sensor element;
- when the signal of every sensor element of the first redundant sensor group is greater than the given corresponding threshold value of each sensor element and/or the signal of every sensor element of the second and/or further redundant sensor group is greater than the given corresponding threshold value of each sensor element, the drive unit being actuated by means of the control unit.

Thus, the redundant sensor groups can jointly better realize a redundancy compensation effect.

According to the present invention, when the signal of any of the sensor elements of the first redundant sensor group is less than the given corresponding threshold value of each sensor element and/or the signal of any of the sensor elements of the second redundant sensor group is less than the given threshold value of each sensor element, the drive unit is turned off in a first time t₁ by means of the control unit. When the signal of at least one sensor element in each redundant sensor group is less than a given corresponding threshold value of each sensor element, this means that a target to be detected, such as a user's hand or finger, has partially left the gripping region, but it may also be that the user's hand has moved position; therefore, when the signal of at least one sensor element in every redundant sensor group is less than the given corresponding threshold value for each sensor element, the control unit assesses at this time that a hand or finger has left the gripping part, and therefore the control unit turns off the drive unit in the first time t₁, so as to avoid danger.

When the signal of every sensor element in the first redundant sensor group is less than the given first threshold value and/or the signal of every sensor element of the nth redundant sensor group is less than the given nth threshold value, the drive unit is turned off in a second time t₂ by means of the control unit, wherein the second time t₂ is less than the first time t₁. When signals of all the sensors in one and/or all the redundant sensor groups of the gripping region are less than the given threshold value for each assembly thereof, this shows that a target to be detected has completely left the detection region, and the electric tool is in a state of not being gripped at all at this time, and therefore the drive unit is turned off in a shorter time by means of the control unit, so as to avoid injury due to a user unintentionally removing a hand and the electric tool still continuing to operate.

### BRIEF DESCRIPTION OF THE DRAWINGS

Embodiments of the present invention are shown in the drawings. The drawings, Description and claims contain many combined features. Those skilled in the art will also conveniently consider these features separately, and combine them to form additional significant combinations.

In the drawings:
- Fig. 1: is a highly simplified longitudinal sectional view of a handheld electric tool designed as an angle grinder, wherein an insert is arranged on a driven shaft of the angle grinder.
- Fig. 2: is a longitudinal sectional view of the angle grinder according to Fig. 1.
- Fig. 3: is a simplified three-dimensional view of the angle grinder according to Figs. 1 and 2 and showing an attached second handle.
- Fig. 4: is a simplified schematic drawing of a sensor element arranged in a gripping region according to an embodiment of the present invention with a partial enlarged view of the sensor elements.
- Fig. 5: is a simplified cross-sectional view of housing with the sensor element arrangement of the embodiment shown in Fig. 4.

### DETAILED DESCRIPTION OF EMBODIMENTS

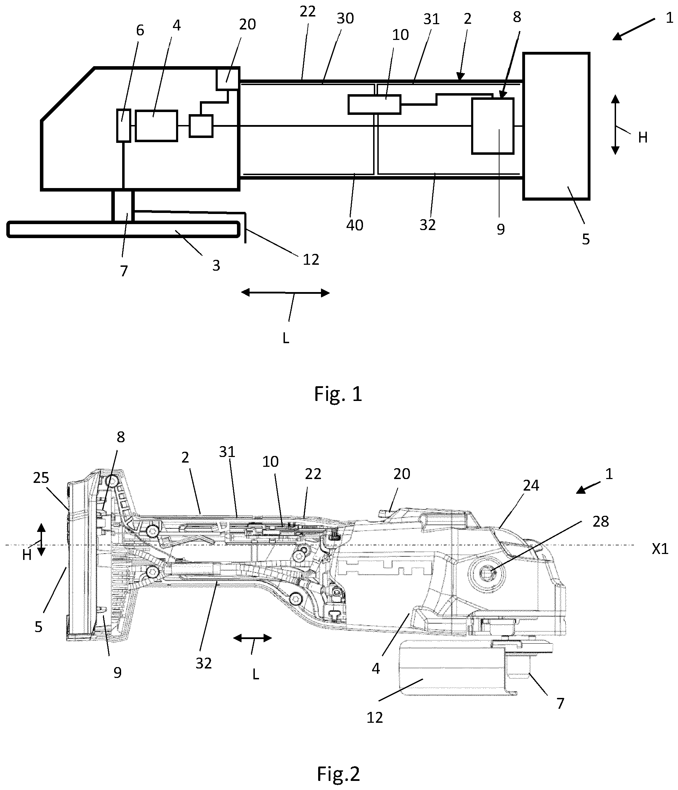

Figs. 1 - 5 show a handheld electric tool 1 according to the present invention, designed as an angle grinder in the illustrations shown. According to an alternative embodiment, the electric tool 1 may also be designed as a drilling machine, a hammer drill, a saw, a chisel hammer, etc.

The electric tool 1 designed as an angle grinder in the drawings has a housing 2 and an insert 3; the insert 3 is for example designed as a cutting disc or grinding wheel, and may be detachably connected to a driven shaft 7 of the electric tool 1. A drive unit 4 (such as an electric motor) for actuating the insert 3 is arranged inside the housing 2 together with a gear mechanism 6. The drive unit 4 designed as an electric motor, the gear mechanism 6 and the driven shaft 7 to which the insert 3 is operably connected are arranged relative to each other and interconnected, such that torque generated by the electric motor 4 may be transferred to the gear mechanism 6, and finally to the driven shaft 7. A free rotating end of the driven shaft 7 protruding downwards from the housing 2, for example, is connected by means of a clamping apparatus (not shown in detail) to the insert 3, here designed as a cutting disc, and thus torque of the driven shaft 7 is directly transferred to the insert 3. The insert 3 may be actuated by the drive unit 4 (in particular designed as an electric motor), and supplied with current by means of a battery 5 connectable to the electric tool 1. Like the housing 2, the battery 5 is not shown in all of the drawings. According to an alternative embodiment (not shown in the drawings), the electric tool 1 may also be supplied with current from a power supply network by means of a power cable.

The electric tool 1 also has a control unit 8; in this case, the control unit 8 is designed to have a main control electronics 9 and a control element 10. The control element 10 is preferably designed as a printed circuit board, and is electrically and electronically connected to the main control electronics 9; in a schematic embodiment of the present invention, the main control electronics 9 is arranged in a region near the battery 5. A user-actuated switch 20 is connected to the main control electronics 9 by means of a power switch.

In a schematic embodiment of the electric tool 1 designed as an angle grinder, a cavity is formed in the housing 2, and is provided with the drive unit 4 (such as an electric motor) for actuating the insert and the control unit 8 for controlling the drive unit 4. In a schematic embodiment of the present invention, a portion of the housing 2 forms a first gripping part 22, and the first gripping part 22 has a first gripping region 23. For example, a portion of the outer periphery of the housing 2 that extends from a portion covering the drive unit 4 to a bottom region connected to a power source is defined as the first gripping region 23, and used for controlling and guiding the electric tool 1 with one or both hands of the user. Furthermore, when one or both hands of the user are performing control in the first gripping region 23, the thumb and the remaining four fingers separately contact the outer periphery of the substantially tubular first gripping part 22, with the palm facing towards the inside of the housing 2, and the encircling hand defines a first gripping direction X1 extending substantially along a central axis of the tubular shape. In addition, when the electric tool 1 is controlled with the first gripping region 23, the user-operable switch 20 is associated with the first gripping region 23.

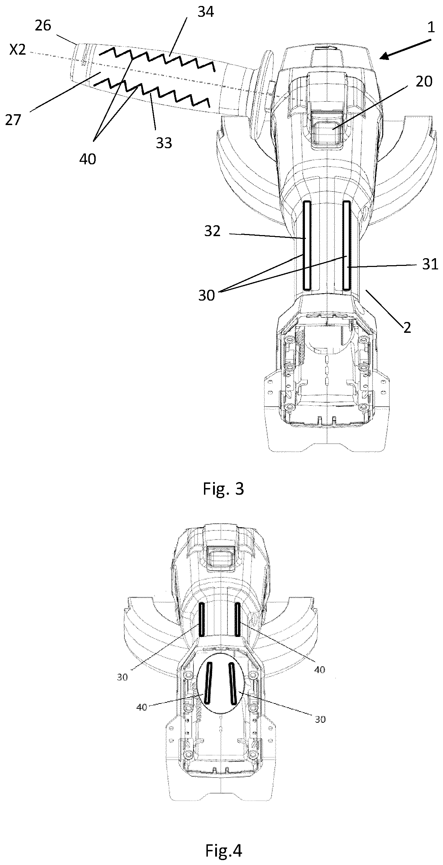

As an alternative solution or in addition to this, the electric tool 1 may have a second gripping part 26, wherein the second gripping part 26 may be detachably connected to the housing 2 of the electric tool 1. Fig. 3 shows a second gripping part 26 of this type; as shown in Figs. 2 and 3, it may be detachably connected to the housing 2 in a region of a connecting point 28. An outer peripheral face of the second gripping part 26 is designed as a second gripping region 27, the second gripping region 27 substantially extending along the entire length of the second gripping part 26, and a second gripping direction X2 is the direction of an axis faced by the palm of the hand when the outer peripheral face of the second gripping part 26 is encircled with the hand.

It can be understood that, according to a schematic embodiment of the present invention, when the electric tool 1 is designed as an angle grinder, the electric tool 1 may simultaneously have the first gripping part 22 and the second gripping part 26, and by separately arranging sensor elements of the first gripping part 22 and the second gripping part 26, detects whether the angle grinder is currently being held with both the first gripping region 23 and the second gripping region 27. Alternatively, it is also possible for the electric tool 1 to only have the first gripping part 22 or the second gripping part 26. For example, when the electric tool 1 is designed as an angle grinder, in particular a small angle grinder, the electric tool 1 may only have the first gripping part 22, in which case it is only necessary to detect whether the first gripping region 23 is gripped correctly in order to switch to the activated state. Alternatively, when the electric tool 1 is designed as a large angle grinder or another category of tool, such as a circular saw, a reciprocating saw or an electric hammer, etc., the electric tool 1 may only have the second gripping part 26; in this case, the second gripping part 26 may for example be a D-shaped or T-shaped handle formed integrally with the housing, or may be an independent attached handle connected to the housing. When the electric tool 1 is designed as a chainsaw, breaker, etc., the electric tool 1 also comprises two gripping parts, e.g. a main handle and an auxiliary handle, or left and right handles. Depending on the category and application of the electric tool 1, activation conditions of the drive unit are set; for example, when a predetermined condition is met by a sensor signal detected by at least two redundant sensor groups arranged in the first gripping region and/or second gripping region, actuation of the drive unit 4 and/or limited activation of the drive unit 4 is realized by means of the control unit 8.

According to the present invention, the sensor elements 31, 32, 33, 34 have independent electronic signal processing parts. They are separately arranged on the first gripping part 22 and/or second gripping part 26, forming at least one failure tolerant redundant sensor group 30, 40. That is, a gripping part of the electric tool of the present invention may be provided with n redundant sensor groups, and preferably n ≥ 1. Each redundant sensor group comprises at least two sensor elements. For example, a first redundant sensor group 30 comprises two sensor elements, a second redundant sensor group 40 comprises three sensor elements, and an nth redundant sensor group comprises m sensor elements, and preferably m ≥ 2. Moreover, the nth redundant sensor group 30, 40 may be directly formed in the first gripping part 22 and/or second gripping part 26, or may be independently arranged in a region near an inner surface of the first gripping part 22 and/or second gripping part 26.

Preferably, the sensor elements 31, 32, 33, 34 are formed of conductive plastic, and formed integrally with the housing 2 formed of insulating plastic. Furthermore, as shown in Fig. 1, the control element 10 is operably connected to at least two sensor elements 31, 32, 33, 34, for example by line or direct contact. In this embodiment, the control element 10 in particular has a control unit and a signal generator, wherein the signal generator is in particular designed for charging the sensor elements 31, 32, 33, 34 at a defined voltage. The control unit is preferably designed for detecting a signal change in at least one sensor element, e.g. inferring the presence of a hand or finger in a detection region if the detected signal of the sensor element is greater than a given threshold value.

The electric tool 1 is described in further detail below, using a vertical direction H, a longitudinal direction Land a transverse direction Q. In this embodiment, the longitudinal direction L is the direction between the battery 5 and the driven shaft 7, and substantially represents the first gripping direction X1. In this case, the vertical direction H substantially corresponds to the direction of extension of the driven shaft 7, and the transverse direction Q is substantially perpendicular to the longitudinal direction L and the vertical direction H and substantially represents the second gripping direction X2.

Referring to Figs. 1 to 3, the first sensor element 31 and the second sensor element 32 independently forms the second redundant sensor group 30. The first sensor element 31 and the second sensor element 32 are respectively connected to the control element 10, the control element 10 respectively detects signals of the first sensor element 31 and second sensor element 32, and transfers the signals to the main control electronics 9, and the signals of the two sensor elements remain redundant with respect to each other. As shown in the figures, the first sensor element 31 and the second sensor element 32 are arranged in a region close to an inside surface of the housing 2, and extend in the first gripping region 23 substantially in the first gripping direction X1. Thus, when the user's hand grips the first gripping region 23, the first gripping direction X1 is substantially parallel to the longitudinal direction of the electric tool 1, so the dimension of the sensor element 31 in the first gripping direction is defined as the length L of the sensor element; in this case, the dimension of the sensor element 31 in a direction substantially perpendicular to the first gripping direction X1 (i.e. substantially corresponding to the direction of extension of the driven shaft 7) is defined as the width B of the sensor element. For the first sensor element 31 and the second sensor element 32, L >> B. Thus, multiple sensor elements may be arranged in a direction perpendicular to the gripping direction. Preferably, for the first sensor element 31 and the second sensor element 32, the width B > 0.1 mm. Thus, when a user's hand in the first gripping region 23 controls the electric tool 1, the sensor region is very sensitive to minute movements of a hand or finger (an object to be detected).

Moreover, an interval between the first sensor element 31 and the second sensor element 32 is greater than 10 mm. Preferably, the first sensor element 31 and the second sensor element 32 are respectively arranged on an upper side and a lower side of the housing, such that the desired high sensitivity to minute movements of a hand is obtained, while simultaneous activation of signals is maximally avoided. If the interval between the first sensor element 31 and the second sensor element 32 is too small, then when the electric tool is placed on the floor or a tabletop, or if there is water on the outer surface of the housing of the electric tool, the first sensor element 31 and the second sensor element 32 are easily blocked simultaneously, which may lead to the first sensor element 31 and the second sensor element 32 being unable to realize a sufficient redundancy compensation function. Therefore, a certain interval is maintained between the first sensor element 31 and the second sensor element 32, preferably greater than 10 mm, which enables a redundancy compensation signal between the first sensor element 31 and the second sensor element 32, independently serving as redundant sensor groups 30, 40, to be more accurate and reliable.

It will be understood that, depending on the size of the drive unit 4 and the design of the housing, the cross-sectional size of the housing 2 in the vertical direction H thereof may vary; for example, as shown in Fig. 2, the diameter of a front housing containing the drive unit 4 is greater than the diameter of a cavity portion containing the control element 10, and a transitional part is provided between the two different diameter portions. Preferably, the first sensor element 31 and/or the second sensor element 32 also vary/varies with the shape of the housing; therefore, the first sensor element 31 and/or the second sensor element 32 is/are substantially parallel in a gripping region of the front housing covering the drive unit 4, or also substantially parallel in the cavity portion at a rear part of the gripping region, but not parallel in a region of the transitional part.

According to a preferred embodiment of the present invention, two failure tolerant redundant sensor groups 30, 40 are provided on the gripping parts. Referring to Fig. 3, according to another embodiment of the present invention, four sensor elements 31, 32, 33, 34 are separately arranged in the first gripping region 23, wherein the first sensor element 31 and the second sensor element 32 form the first redundant sensor group 30, and the third sensor element 33 and the fourth sensor element 34 form the second redundant sensor group 40.

Alternatively, two or more than two redundant sensor groups 30, 40 may be respectively arranged on the first gripping part 22 and/or the second gripping part 26. For example, two redundant sensor groups 30, 40 are arranged on the first gripping part 22, one sensor group is arranged on the second gripping part 26, and a fourth redundant sensor group may further be arranged in a region where a protective apparatus 12 is mounted. Moreover, each redundant sensor group is also not limited to comprising two sensor elements; depending on the size of the detection region, one, three, four or more sensor elements may be provided. Thus, two or more failure tolerant redundant sensor groups provide sufficient redundant sensor signals, and these signals further verify each other, increasing safety of operation and detection.

The gripping part of the electric tool may further be provided with another sensor element, which forms an extra redundancy compensation system with at least one of the redundant sensor groups 30, 40.

The working principles of the second redundant sensor group 40 and the first redundant sensor group 30 are similar, wherein the third sensor element 33 and the fourth sensor element 34 are respectively connected to the control element 10, the control element 10 individually detects signals of the third sensor element 33 and the fourth sensor element 34, and transfers the signals to the main control electronics 9, and the signals of the two sensor elements remain redundant with respect to each other. Thus, the risk of a detection error by the sensor elements is reduced in a simple way. Each sensor element in the first and second redundant sensor groups compensates for each other's redundancy, advantageously achieving redundant monitoring of a target being detected in the gripping region, for example a hand or finger, and thus achieving high safety for an operator during operation of the electric tool.

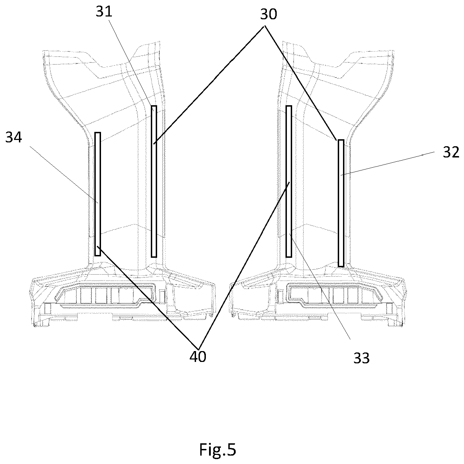

The sensor elements of each redundant sensor group 30, 40 are alternately arranged, and an interval between the sensor elements is greater than 10 mm. For example, as show in Fig. 5, the first sensor element 31 is arranged in an upper region of a left half-shell of the housing 2, and the second sensor element 32, which forms redundancy compensation therewith, is arranged in a lower region of a right half-shell of the housing 2. The third sensor element 33 is arranged in an upper region of the right half-shell of the housing 2, and the fourth sensor element 34, which forms redundancy compensation therewith, is arranged in a lower region of the left half-shell of the housing 2. The first and second sensor elements 31, 32 are substantially symmetric along a diameter of the gripping part, and likewise, the third and fourth sensor elements 33, 34 are also substantially symmetric along a diameter of the gripping part, and thus, the distance between two sensor elements in each redundant sensor group is the maximum, so as to obtain more sensitive and more accurate detection. Moreover, the interval between the sensor elements is greater than 10 mm, so as to avoid synchronous interference of signals.

The first redundant sensor group 30 and the second redundant sensor group 40 are jointly configured such that when a signal of every sensor element 31, 32 of the first redundant sensor group 30 is greater than a given corresponding threshold value of each sensor element 31, 32 and/or a signal of every sensor element 33, 34 of the second redundant sensor group 40 is greater than a given corresponding threshold value of each sensor element 33, 34, the drive unit 4 is actuated by means of the control unit 8. Thus, when the first redundant sensor group 30 encounters a fault or fails, the second redundant sensor group 40 can work independently. Alternatively, in a working process of the electric tool, a minute movement of the user's hand on the gripping region still causes the hand or a finger to contact a further sensor element and / or changing the signal of the first sensor element. This signal changes are further evaluated and used for signal validation and user detection.

According to a preferred embodiment of the present invention, the drive unit 4 is actuated by means of the control unit 8 only when the signal of every sensor element 31, 32 in the first redundant sensor group 30 is greater than a given corresponding threshold value of each sensor element 31, 32, and/or the respective signal of every sensor element 33, 34 in the second redundant sensor group 40 is greater than a given corresponding threshold value of each sensor element 33, 34.

The sensor elements 31, 32, 33, 34, 35 currently are all designed as capacitive sensor elements, and a change of charge, i.e. a sensor signal, in the relevant sensor elements 31, 32, 33, 34, 35 may be determined in conjunction with the control element 10.

The present invention further provides a method for controlling the handheld electric tool of any of the above embodiments, and here taking the gripping part of the electric tool to have two redundant sensor groups 30, 40 as an example, the method of the present invention is described in detail. The method comprises the following steps:
- a control unit 8 detecting respective signals of a first sensor element 31 and a second sensor element 32 in a first redundant sensor group 30;
- the control unit 8 detecting respective signals of a third sensor element 33 and a fourth sensor element 34 in a second redundant sensor group 40;
- comparing the respective signals of the first sensor element 31 and the second sensor element 32 with a given corresponding threshold value of each sensor element;
- comparing the respective signals of the third sensor element 33 and the fourth sensor element 34 with a given corresponding threshold value of each sensor element; and
- when the signals of the first sensor element 31 and the second sensor element 32 of the first redundant sensor group 30 are both greater than the given corresponding threshold value, and/or the signals of the third sensor element 33 and the fourth sensor element 34 of the second redundant sensor group 40 are both greater than the given corresponding threshold value, the drive unit 4 being actuated by means of the control unit 8.

The control method for the handheld electric tool according to the present invention provides sufficient redundant sensor signals, and these signals further verify each other, increasing safety of operation and detection.

In addition, when the signal of the first sensor element 31 or the second sensor element 32 of the first redundant sensor group 30 is less than the given first threshold value, and/or the signal of the third sensor element 33 or the fourth sensor element 34 of the second redundant sensor group 40 is less than the given second threshold value, the drive unit 4 is turned off in a first time t₁ by means of the control unit 8. At this time, the control unit 8 assesses that the user's hand has at least partially left the gripping region, and then the control unit turns off the drive unit in the first time t₁. The first redundant sensor group 30 and the second redundant sensor group 40 form redundancy compensation with each other, further increasing safety and reliability of detection.

When the signals of the first sensor element 31 and the second sensor element 32 of the first redundant sensor group 30 are both less than the given first threshold value, and the signals of the third sensor element 33 and the fourth sensor element 34 of the second redundant sensor group 40 are less than the given second threshold value, the drive unit 4 is turned off in a second time t₂ by means of the control unit 8, wherein the second time t₂ is less than the first time t₁. Thus, when signals of all the sensors of the gripping region all show that a target to be detected has left the detection region, the electric tool is in a state of not being gripped at all at this time, and therefore the drive unit is turned off in the minimum time by means of the control unit, so as to avoid injury due to a user unintentionally removing a hand and the electric tool still continuing to operate.

The Debouncing of the sensor will be done on vector level. If a single element will change its state, the full sum-debouncing-time is capable for this single element. If two (or more) elements will change its state, the sum-debouncing-time will split up and the tool will switch off faster.

Further the debouncing counter could increase dependently of the amount of changed elements. Therefore, the user feel more comfort at changing the grip position and the user can faster switch-off if the power tool is fully released (ungripped).

Therefore, the first sensor element 31 and the second sensor element 32 in the first redundant sensor group 30 not only form redundancy compensation for each other, but also allow the drive unit 4 to be turned off more quickly in a dangerous scenario by means of the control unit 8. As described above, the number of sensor elements 31, 32, 33, 34, 35 in the redundant sensor groups 30, 40 is not limited to two; the number may also be one, three, four or more. In an alternative embodiment, it may further be provided that any simple combination of the sensor elements 31, 32, 33, 34 is provided. As an alternative to this, another sensor element 35 may also be provided, which forms an extra redundancy compensation system with the redundant sensor groups.

## Claims

1. Handheld electric tool (1) including a drive unit (4), and a control unit (8) for actuating the drive unit (4), and at least two sensor elements (31, 32, 33, 34, 35) operably connected to the control unit (8), wherein the electric tool (1) further comprises at least one gripping part (22, 26), **characterized in that**
the sensor elements (31, 32, 33, 34, 35) are separately arranged on the gripping parts (22, 26) and/or have independent electronic signal processing parts, to form at least one failure tolerant redundant sensor group (30, 40).

2. Handheld electric tool according to Claim 1, **characterized in that**
the gripping part (22, 26) comprises a gripping region (23, 27) defining a gripping direction (X1, X2), and is used for controlling and guiding the electric tool (1) with one or both hands of a user contacting the gripping region (23, 27) at least partially around the gripping direction (X1, X2), and a length L in the gripping direction (X1, X2) of each sensor element (31, 32, 33, 34, 35) in the redundant sensor group (30, 40) is much greater than a width B thereof, wherein the width is a dimension of the sensor element substantially perpendicular to the gripping direction (X1, X2), and the width B > 0.1 mm.

3. Handheld electric tool according to Claim 2, **characterized in that**
two or more failure tolerant redundant sensor groups (30, 40) are provided on the gripping parts (22, 26).

4. Handheld electric tool according to Claim 3, **characterized in that**
the sensor elements (31, 32, 33, 34, 35) of each redundant sensor group are arranged alternately at intervals from each other, wherein the interval between the sensor elements (31, 32, 33, 34, 35) is greater than 10 mm.

5. Handheld electric tool according to Claim 3, **characterized in that**
the gripping part (22, 26) comprises a first gripping part (22, 26) and a second gripping part (22, 26), and the two or more redundant sensor groups (30, 40) are respectively arranged on the first gripping part (22) and the second gripping part (26).

6. Handheld electric tool according to any one of Claims 1 - 5, **characterized in that** the sensor elements (31, 32, 33, 34, 35) are capacitive sensors.

7. Method for operating a handheld electric tool (1), the electric tool (1) including a drive unit (4), and a control unit (8) for actuating the drive unit (4), and at least two capacitive sensor elements (31, 32, 33, 34, 35) operably connected to the control unit (8), wherein the electric tool (1) further comprises at least one gripping part (22, 26), and the at least two sensor elements (31, 32, 33, 34, 35) are separately arranged on the gripping part (22, 26), forming at least one failure tolerant redundant sensor groups (30, 40), the method being **characterized by** the following method steps:
- detecting a signal of each sensor element of the redundant sensor group (30, 40), and comparing the signal with a given corresponding threshold value of each sensor element;
- when the signal of every sensor element of the redundant sensor group (30, 40) is greater than the given corresponding threshold value of each sensor element, the drive unit (4) being actuated by means of the control unit (8).

8. Method according to Claim 7, **characterized in that**
two or more failure tolerant redundant sensor groups (30, 40) are provided on the gripping parts (22, 26).

9. Method according to Claim 8, **characterized in that**
- detecting a signal of each sensor element of first redundant sensor group (30, 40), and comparing the signal with a given corresponding threshold value of each sensor element;
- detecting a signal of each sensor element of second and/or further redundant sensor group (30, 40), and comparing the signal with a given corresponding threshold value of each sensor element;
- when the signal of every sensor element of the first redundant sensor group (30, 40) is greater than the given corresponding threshold value of each sensor element and/or the signal of every sensor element of the second and/or further redundant sensor group (30, 40) is greater than the given corresponding threshold value of each sensor element, the drive unit (4) being actuated by means of the control unit (8).

10. Method according to Claim 8, **characterized in that,**
when any signal of each sensor element of the first redundant sensor group (30, 40) is less than the given corresponding threshold value of each sensor element and/or any signal of each sensor element of the second and/or further redundant sensor group (30, 40) is less than the given corresponding threshold value of each sensor element, the drive unit (4) is turned off in a first time t₁ by means of the control unit (8).

11. Method according to Claim 10, **characterized in that**
when the signal of every sensor element (31, 32) in the first redundant sensor group (30, 40) is less than the given corresponding threshold value of each sensor element and the signal of every sensor element of the second and/or further redundant sensor group (30, 40) is less than the given corresponding threshold value of each sensor element, the drive unit (4) is turned off in a second time t₂ by means of the control unit (8), wherein the second time t₂ is less than the first time t₁.
